# EUROPÄISCHE PATENTSCHRIFT

(11) **EP 0 434 154 B1**
(45) Veröffentlichungstag und Bekanntmachung des Hinweises auf die Patenterteilung: **15.03.1995**
(21) Anmeldenummer: 90203349.7
(22) Anmeldetag: 17.12.1990
(51) Int. Cl.: H01L 27/146

(54) **Anordnung zum Auslesen einer Sensormatrix**
Device for reading a sensor matrix
Dispositif pour lire une matrice photosensible

(30) Priorität: 21.12.1989 DE 3942200
(43) Veröffentlichungstag der Anmeldung: 26.06.1991
(73) Patentinhaber: Philips Patentverwaltung GmbH, 22335 Hamburg (DE); Philips Electronics N.V., 5621 BA Eindhoven (NL)
(72) Erfinder: Wieczorek, Herfried, Dr., W-5100 Aachen (DE)
(74) Vertreter: von Laue, Hanns-Ulrich, Dipl.-Ing.

(56) Entgegenhaltungen:
- EP-A- 0 211 720
- DE-A- 3 531 448
- GB-A- 2 037 121
- JP-A- 1 103 860

## Beschreibung

Die Erfindung betrifft eine Anordnung zum Auslesen der Ladungen mehrerer in einer Matrix in Zeilen und Spalten angeordneter licht- oder röntgenstrahlenempfindlicher Sensorelemente, welche jeweils einen elektrischen Schalter aufweisen, mit je Sensorspalte einer gemeinsamen Ausleseleitung und mit je Sensorzeile einer Schaltleitung, über die die Schalter der Sensoren aktivierbar sind, so daß die Ladungen der Sensorelemente der aktivierten Zeile über die gemeinsamen Ausleseleitungen der Sensorspalten abfließen.

Eine derartige Anordnung ist beispielsweise aus der DE-A-35 31 448 bekannt. Es ist dort für ein Röntgen-Bilderfassungsgerät eine Matrix von Fotozellen vorgesehen, deren Ladungen ausgelesen werden, indem über je Zeile eine Schaltleitung die jedem Sensor zugeordneten Schalter aktiviert werden. Das Auslesen der in den Sensoren gespeicherten Ladungen erfolgt spaltenweise über je eine gemeinsame Ausleseleitung. Bei derartigen Anordnungen besteht das Problem, daß das ausgelesene Signal infolge der parasitären Kapazitäten der Ausleseleitungen und der Schalter, über die die Ladung jedes Sensorelementes ausgelesen wird, negativ beeinflußt wird.

Es ist Aufgabe der Erfindung, eine Anordnung der eingangs genannten Art anzugeben, welche hinsichtlich dieses Problems ein verbessertes Verhalten zeigt.

Diese Aufgabe ist erfindungsgemäß dadurch gelöst, daß für jede Sensoren-Spalte zusätzlich mehrere segmentierte Ausleseleitungen vorgesehen sind, die jeweils nur mit einigen Sensorelementen einer Spalte über deren Schalter verbindbar sind und die mittels weiterer elektrischer Schalter einzeln auf die gemeinsame Ausleseleitung der Spalte schaltbar sind und daß für einen Auslesevorgang einer Sensorzeile in jeder Spalte diejenigen segmentierten Ausleseleistungen auf die gemeinsamen Ausleseleitungen schaltbar sind, die mit der aktivierten Sensorzeile über deren Schalter verbunden sind.

In jedem der Sensorelemente der Matrix wird eine solche Ladungsmenge gespeichert, die der in einem bestimmten Zeitraum auf das Sensorelement aufgetroffenen Licht- bzw. Röntgenstrahlenmenge entspricht. Diese gespeicherte Ladungsmenge wird über elektrische Schalter ausgelesen, von denen jedes Sensorelement einen aufweist. Je Sensorelementenzeile ist eine Schaltleitung vorgesehen. Wird auf eine dieser Schaltleitungen ein entsprechendes Schaltsignal gegeben, so werden die Schalter der Sensorelemente dieser Zeile aktiviert und es werden die in den Sensorelementen gespeicherten Ladungsmengen ausgelesen. Dies geschieht über Ausleseleitungen, von denen je Sensorelementenspalte je eine vorgesehen ist. Hierbei besteht das Problem, daß beim Auslesen einer Zeile der Sensorelemente in jeder Spalte sämtliche Schalter der in dieser Spalte vorgesehenen Sensorelemente mit der Ausleseleitung verknüpft sind. Auch wenn die übrigen Schalter mit Ausnahme der gerade ausgelesenen Sensorzeile geschlossen sind, so weisen sie doch, ebenso wie die Ausleseleitung selbst, parasitäre Kapazitäten auf, die dazu führen, daß das ausgelesene Signal mit einem Rauschen überlagert wird.

Bei der erfindungsgemäßen Anordnung ist diese Problematik dadurch entschärft, daß in jeder einzelnen Spalte der Sensormatrix zusätzlich zu der gemeinsamen Ausleseleitung mehrere segmentierte Ausleseleitungen vorgesehen sind. Die segmentierten Ausleseleitungen weisen Schalter auf, über die sie mit der gemeinsamen Ausleseleitung verbindbar sind. Die einzelnen Sensorelemente der betreffenden Spalte sind nicht mehr mit der gemeinsamen Ausleseleitung, sondern mit den segmentierten Ausleseleitungen verbunden. Es sind dabei mit einer segmentierten Ausleseleitung jeweils nur einige der Schalter der Sensoren einer Spalte verbunden. Sind beispielsweise in einer Spalte neun Sensorelemente vorgesehen, so können drei segmentierte Ausleseleitungen vorgesehen sein, mit denen jeweils drei Sensorelemente über deren Schalter verbindbar sind.

Für einen Auslesevorgang werden in bekannter Weise über eine Schaltleitung je Zeile die Schalter der Sensorelemente dieser Zeile aktiviert. Der Auslesevorgang geschieht nun in der Weise, daß die in der betreffenden Sensorzeile vorhandenen Sensorelemente auf die jeweils zugeordneten segmentierten Ausleseleitungen geschaltet werden. Die segmentierten Ausleseleitungen selbst wiederum sind mittels weiterer elektrischer Schalter auf die gemeinsame Ausleseleitung geschaltet. Es ergibt sich ein verbessertes Rauschverhalten, daß darin begründet liegt, daß jede segmentierte Ausleseleitung nur mit einem relativ kleinen Teil der Schalter der Sensorelemente einer Spalte verbunden ist. Auch die gemeinsame Ausleseleitung weist wiederum relativ wenige Schaltelemente auf, da nur so viele Schaltelemente erforderlich sind, wie segmentierte Ausleseleitungen vorhanden sind. Das verbesserte Rauschverhalten bei dieser Anordnung wird umso deutlicher, je mehr Sensorelemente in einer Spalte vorgesehen sind. Da in praktischen Anordnungen meist über tausend Sensorelemente in einer Spalte vorgesehen sind, ist in diesen Fällen das Rauschen deutlich vermindert.

Die Herstellung der für die segmentierten Ausleseleitungen zusätzlich erforderlichen elektrischen Schalter kann in einem gemeinsamen Herstellungsprozeß mit den übrigen elektrischen Schaltern geschehen, wenn, wie nach einer weiteren Ausgestaltung der Erfindung vorgesehen ist, als elektrische Schalter sowohl der Sensorelemente wie auch der segmentierten Ausleseleitungen Dünnfilmtransistoren vorgesehen sind.

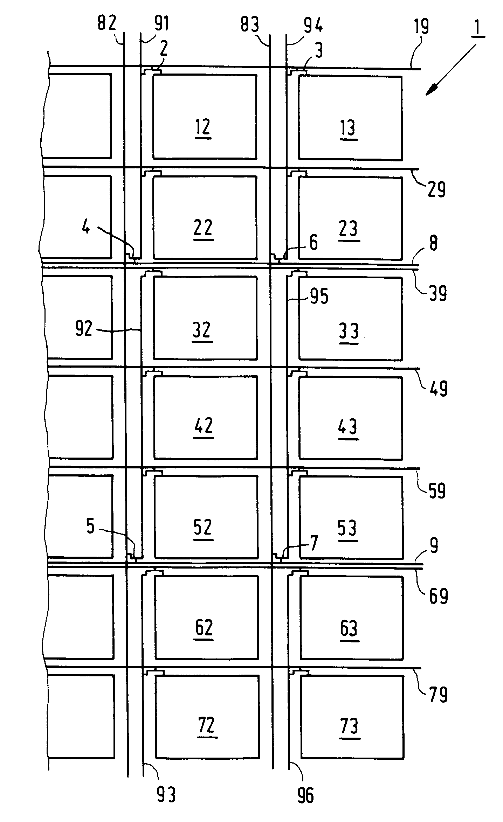

Anhand der einzigen Figur wird ein Ausführungsbeispiel der Erfindung näher erläutert.

In der Figur ist ein Teil einer Sensormatrix 1 dargestellt, welche beispielsweise insgesamt zweitausend Sensorelemente je Spalte und je Zeile aufweisen kann. Eine solche Sensormatrix kann beispielsweise in der hochauflösenden Radiografie eingesetzt werden.

Der in der Figur dargestellte Teil der Sensormatrix weist Sensorelemente 12, 13, 22, 23,..., 73 auf. Diese Sensorelemente sind zeilen- und spaltenweise in einer Matrix angeordnet. Die Sensorelemente selbst sind in der Figur nur schematisch angedeutet. Ist eine derartige Sensormatrix beispielsweise zur Anwendung in der Radiografie vorgesehen, so handelt es sich um röntgenstrahlenempfindliche Sensorelemente, welche einen in der Figur nicht dargestellten Sensor aufweisen, mittels dessen eine Ladungsmenge in einer in jedem Sensorelement vorgesehenen Kapazität gespeichert wird. Diese gespeicherte Ladungsmenge ist proportional zu der in einer vorgegebenen Zeitspanne aufgetroffenen Strahlungsmenge.

Jedes der in der Figur dargestellten Sensorelemente weist einen elektrischen Schalter 2 auf, bei dem es sich beispielsweise um einen Dünnfilmtransistor handeln kann. Diese Dünnfilmtransistoren 2 können mit den Sensorelementen 12, ..., 73 in einem gemeinsamen Fertigungsprozeß gewonnen werden.

Bei der ausschnittsweisen Darstellung in der Figur sind für die erste Zeile einer Matrix nur die Sensorelemente 12 und 13 vollständig dargestellt. Entsprechendes gilt für die weiteren Zeilen, in denen jeweils zwei Sensorelemente dargestellt sind. Ferner sind in der Figur für jede Spalte sieben Sensorelemente dargestellt. So weist beispielsweise eine Spalte die Sensorelemente 12, 22, 32, 42, 52, 62 und 72 auf.

Die Sensorelemente einer Zeile, bzw. genauer gesagt deren elektrische Schalter 2, sind mittels einer der jeweiligen Zeile zugeordneten Schaltleitung 19, 29, 39, 49, 59, 69 oder 79 aktivierbar. So sind in dem in der Figur dargestellten Ausführungsbeispiel die Schalter 2 der beiden Sensorelemente 12 und 13 über die für diese Zeile vorgesehene Schaltleitung 19 aktivierbar. Entsprechendes gilt für die weiteren Schaltleitungen 29, 39, 49, 59, 69 und 79 für die weiteren Zeilen.

Für jede Spalte der Sensorelemente ist eine gemeinsame Ausleseleitung vorgesehen. Für die Spalte der Sensorelemente 12, 22, 32, 42, 52, 62, 72 ist dies die gemeinsame Ausleseleitung 82. Für die Spalte der Sensorelemente 13, 23, 33, 43, 53, 63, 73 ist dies die gemeinsame Ausleseleitung 83.

Je Spalte sind jedoch zusätzlich noch mehrere segmentierte Ausleseleitungen vorgesehen. So sind beispielsweise die Sensorelemente 12 und 22 mit einer segmentierten Ausleseleitung 91 verbunden, welche über einen elektronischen Schalter 4, bei dem es sich ebenso wie bei den elektronischen Schaltern 2 um Dünnfilmtransistoren handeln kann, auf die gemeinsame Ausleseleitung 82 dieser Spalte schaltbar ist. Dazu ist eine Schaltleitung 8 vorgesehen, mittels welcher die Schalter 4 und 6 der segmentierten Ausleseleitungen 91 bzw. 94 aktiviert werden können. Die weiteren in dieser Spalte vorgesehenen Sensorelemente 32, 42 und 52 sind mittels ihrer Schalter 2 auf die segmentierte Ausleseleitung 92 schaltbar, welche ihrerseits wiederum mittels eines elektronischen Schalters 5 auf die gemeinsame Ausleseleitung 82 dieser Spalte schaltbar ist. Dazu ist eine Schaltleitung 9 vorgesehen, über die die elektrischen Schalter 5 der segmentierten Ausleseleitung 92 und der elektrische Schalter 7 der segmentierten Ausleseleitung 95 aktiviert werden kann. In der ausschnittsweisen Darstellung der Figur ist für die weiteren in der Figur dargestellten Sensorelemente 62 und 72 dieser Spalte eine weitere segmentierte Ausleseleitung 93 angedeutet, welche ebenfalls in in der Figur nicht dargestellter Weise mit der gemeinsamen Ausleseleitung 82 verbunden ist. Weitere, gegebenenfalls in dieser Spalte vorgesehene, in der Figur jedoch nicht dargestellte Sensorelemente, werden in entsprechender Weise über segmentierte Ausleseleitungen mit der gemeinsamen Ausleseleitung 82 dieser Spalte verbunden. Dies geschieht in der Weise, daß weitere Schaltleitungen vorgesehen sind, welche die Schalter der segmentierten Ausleseleitungen aktivieren können, so daß die segmentierten Ausleseleitungen auf die jeweils gemeinsame Ausleseleitung schaltbar sind.

Sollen nun beispielsweise die Sensorelemente der dritten Zeile, d.h. also gemäß der ausschnittsweisen Darstellung in der Figur, die Sensorelemente 32 und 33 ausgelesen werden, so sind deren elektrische Schalter 2 über die Schaltleitung 39 zu aktivieren. Die Ladung des Sensorelementes 32 kann dann auf die segmentierte Ausleseleitung 92 und die des Sensorelementes 33 auf die segmentierte Ausleseleitung 95 abfließen. Da nur die Schaltleitung 39 aktiviert ist, werden in diesem Falle nur die diesen Sensorelementen zugeordneten Schalter leitend geschaltet. Alle anderen Schalter von Sensorelementen in anderen Zeilen sind gesperrt. Die segmentierten Ausleseleitungen 92 und 95 wiederum werden für den Auslesevorgang mittels der ihnen zugeordneten elektrischen Schalter 5 bzw. 7 mittels eines entsprechenden Schaltsignals auf der Schaltleitung 9 aktiviert, so daß die segmentierte Ausleseleitung 92 nunmehr mit der für diese Spalte vorgesehenen gemeinsamen Ausleseleitung 82 verbunden ist. Entsprechendes gilt für die segmentierte Ausleseleitung 95, welche nach Aktivierung des Schalters 7 nun mit der für diese Spalte vorgesehenen gemeinsamen Ausleseleitung 83 verbunden ist. Im Ergebnis fließt nun also die Ladung vom Sensorelement 32 über dessen elektrischen Schalter 2 auf die segmentierte Ausleseleitung 92 und von dieser wiederum über den elektrischen Schalter 5 auf die gemeinsame Ausleseleitung 82. Entsprechendes gilt für das Sensorelement 33 sowie weitere, in dieser Zeile eventuell vorhandene, jedoch in der Figur nicht dargestellte Sensorelemente.

Ein entsprechender Auslesevorgang ist in allen Zeilen nacheinander vornehmbar, wobei jeweils die der auszulesenden Zeile in jeder Spalte zugeordneten Ausleseleitungen auf die gemeinsame Ausleseleitung zu schalten sind.

Das verbesserte Rauschverhalten infolge geringerer parasitärer Kapazitäten ergibt sich dadurch, daß die gemeinsame Ausleseleitung jeder Spalte nur über relativ wenige elektrische Schalter mit den segmentierten Ausleseleitungen verbunden sind. Jede segmentierte Ausleseleitung ihrerseits ist wiederum nur mit einigen Sensorelementen der Spalte verbunden. Im Ergebnis führt dies dazu, daß bei einem Ausleseprozeß über eine segmentierte Leitung und eine gemeinsame Ausleseleitung diese beiden Leitungen mit deutlich weniger elektrischen Schaltern in Verbindung stehen, als Sensorelemente in der betreffenden Spalte vorhanden sind. Dieser Effekt wird umso deutlicher, je mehr Sensorelemente pro Spalte vorgesehen sind. Dieser Effekt wird bereits an dem in der Figur dargestellten Ausschnitt einer Matrix deutlich, da für diesen Beispielsfall die Ausleseleitung nach der Anordnung nach dem Stande der Technik mit sieben Schaltern mit den sieben Elementen einer Spalte verbunden wäre. Bei der erfindungsgemäßen Lösung ist jedoch eine segmentierte Ausleseleitung nur mit drei Schaltern versehen und die gemeinsame Ausleseleitung mit zwei Schaltern, so daß sich bereits bei dieser relativ kleinen Anordnung ein Vorteil ergibt. Bei größeren Anordnungen mit z.B. zweitausend Sensorelementen je Spalte ergibt sich durch die erfindungsgemäße Anordnung eine Verminderung der Kapazität in den Ausleseleitungen jeder Spalte um etwa den Faktor 6 bis 7.

## Patentansprüche

1. Anordnung zum Auslesen der Ladungen mehrerer in einer Matrix in Zeilen und Spalten angeordneter licht- oder röntgenstrahlenempfindlicher Sensorelemente (12, 13, 22, 23,..., 72, 73), welche jeweils einen elektrischen Schalter (2) aufweisen, mit je Sensoren-Spalte einer gemeinsamen Ausleseleitung (82, 83) und mit je Sensoren-Zeile einer Schaltleitung (19, 29,...), über die die Schalter (2) der Sensoren (12, 15, 22, 23,..., 72, 73) aktivierbar sind, so daß die Ladungen der Sensorelemente (12, 13, 22, 23,..., 72, 73) der aktivierten Zeile über die gemeinsamen Ausleseleitungen (82, 83) der Sensoren-Spalten abfließen,
dadurch gekennzeichnet, daß für jede Sensoren-Spalte zusätzlich mehrere segmentierte Ausleseleitungen (91, 92, 93,...) vorgesehen sind, die jeweils nur mit einigen Sensorelementen (12, 22,..., 72, ...) einer Spalte über deren Schalter (2) verbindbar sind und die mittels weiterer elektrischer Schalter (4, 5,...) einzeln auf die gemeinsame Ausleseleitung (82, 83) ihrer Spalte schaltbar sind und daß für einen Auslesevorgang einer Sensorzeile in jeder Spalte diejenigen segmentierten Ausleseleitungen (91, 92,...) auf die gemeinsamen Ausleseleitungen (82, 83) schaltbar sind, die mit der aktivierten Sensorzeile über deren Schalter (2) verbunden sind.

2. Anordnung nach Anspruch 1,
dadurch gekennzeichnet, daß als elektrische Schalter (2, 4, 5, 6, 7) sowohl der Sensorelemente (12, 13, 22, 23,..., 72, 73) wie auch der segmentierten Ausleseleitungen (82, 83) Dünnfilmtransistoren vorgesehen sind.

## Claims

1. A device for reading the charges of several light-sensitive or X-ray sensitive sensor elements (12, 13, 22, 23, ..., 72, 73) which are arranged in rows and columns in a matrix, each sensor element comprising a respective electric switch (2), for each sensor column there being provided a common read line (82, 83) while for each sensor row there is provided a switching line (19, 29, ...) via which the switches (2) of the sensors (12, 15, 22, 23, ..., 72, 73) can be activated so that the charges of the sensor elements (12, 15, 22, 23, ..., 72, 73) of the activated row are output via the common read lines (82, 83) of the sensor columns, characterized in that for each sensor column there are provided several segmented read lines (91, 92, 93, ...), each of which can be connected, via the relevant switches (2), to a few sensor elements (12, 22, ..., 72, ...) of a column only and which can be individually connected, via further electric switches (4, 5, ...), to the common read line (82, 83) of the column, and in that for a read operation of a sensor row only the segmented read lines (91, 92, ...) which are connected to the activated sensor row via their switches (2) are connectable to the common read lines (82, 83) in each column.

2. A device as claimed in Claim 1, characterized in that thin-film transistors are used for the electric switches (2, 4, 5, 6, 7) of the sensor elements (12, 13, 22, 23, ..., 72, 73) as well as of the segmented read lines (82, 83).

## Revendications

1. Dispositif pour la lecture des charges de plusieurs éléments sensibles de capteurs (12, 13, 22, 23,..., 72, 73) réagissant à la lumière ou aux rayons X agencés selon une matrice de lignes et de colonnes, ces capteurs comportant chacun un commutateur électrique (2), avec une ligne de lecture commune (82, 83) par colonne de capteurs et avec une ligne de commutation (19, 29,...) par ligne de capteurs par lesquelles les commutateurs (2) des capteurs (12, 15, 22, 23,..., 72, 73) peuvent être activés, de telle sorte que les charges des capteurs (12, 13, 22, 23,..., 72, 73) de la ligne activée s'écoulent via les lignes de lecture communes (82, 83) des colonnes de capteurs, caractérisé en ce que, pour chaque colonne de capteurs sont prévues, en outre, plusieurs lignes de lecture segmentées (91, 92, 93,...), qui peuvent n'être raccordées respectivement qu'à certains capteurs (12, 22,..., 72,...) d'une colonne via leurs commutateurs (2) et qui peuvent être commutées, via d'autres commutateurs électriques, individuellement sur la ligne de lecture commune (82, 83) de leur colonne et en ce que, pour effectuer une opération de lecture d'une ligne de capteurs, dans chaque colonne, on peut commuter les lignes de lecture segmentées (91, 92,...) sur les lignes de lecture communes (82, 83) qui sont connectées à la ligne de capteurs activée via leurs commutateurs (2).

2. Dispositif selon la revendication 1, caractérisé en ce que des transistors à couches minces sont prévus comme commutateurs électriques (2, 4, 5, 6, 7) des capteurs (12, 13, 22, 23, ..., 72, 73) ainsi que des lignes de lecture segmentées (82, 83).
